# EUROPEAN PATENT APPLICATION

(11) **EP 2 178 001 A1**
(43) Date of publication of application: **21.04.2010**
(21) Application number: 07790712.9
(22) Date of filing: 12.07.2007
(51) Int. Cl.: G06F 17/12

(54) **CALCULATION DEVICE, CALCULATION METHOD AND CALCULATION PROGRAM**

(71) Applicant: Fujitsu Limited, Kawasaki-shi, Kanagawa 211-8588 (JP)
(72) Inventor: MIYOSHI, Ikuo, Kawasaki-shi Kanagawa 211-8588 (JP)
(74) Representative: Ward, James Norman
(86) International application number: PCT/JP2007/063918
(87) International publication number: WO 2009/008086

(57) **Abstract**

Transmission overhead that takes a long period of time in calculating processes with an iterative solution technique is to be suppressed. After its own calculation result is calculated with the calculating processes, calculating processes are repeatedly executed without waiting for a determination as to whether the calculation result is significant. After the calculating processes are started and when an indication that the significance can be determined is transmitted because of reception of calculation results from other computer apparatuses via transmission units, or, when a request as to whether the significance can be determined is sent and an indication that the significance can be determined is obtained as a result of the request, the significance of its own calculation result is determined. When it is determined that the calculation result is significant, the calculation processes are suspended.

## Description

### TECHNICAL FIELD

The present invention relates to a computer apparatus, a calculation method, and a calculation program.

### BACKGROUND ART

Conventionally, calculations in computer simulations such as car collision simulations and protein structural analyses are performed with an iterative solution technique, with which a series of formulas are repeatedly performed for each calculation processor. For example, in the iterative solution technique with linear simultaneous equations, a solution vector "x" is obtained for the equation "Ax = b" with the given "matrix A" and "vector b". When "matrix A" is a sparse matrix whose elements are mostly "0", it is common that a solution vector is obtained, for example, using a convergent-operation type iterative solution technique such as a conjugate gradient method.

Furthermore, in the convergent-operation type iterative solution technique, a series of calculating processes are repeatedly performed, including an approximate solution computing calculation for calculating an approximate solution vector "xi" (which represents "x" corresponding to "i") and an approximate solution accuracy calculation for calculating "norm(|b - Axi|)" (which indicates accuracy of an approximate solution vector), so that a solution vector "x" converged at sufficient accuracy can be obtained (see Nonpatent Document 1 and Nonpatent Document 2). The approximate solution accuracy calculation includes a summation calculation of "norms" of a residual vector. It is common that a series of calculating processes are repeatedly performed when a "norm" calculated using a summation calculation is equal to or higher than a predetermined convergence-determination threshold value "ε", whereas, a convergence-determination, determining the calculated approximate solution vector "xi" as the solution vector "x", is performed when the "norm" is lower than a convergence-determination threshold value "ε".

Furthermore, for example, a distributed memory parallel computing apparatus with a plurality of processors is known, e.g., the invention disclosed in Patent Document 1 (Japanese Laid-open Patent Publication No. 2002-288147). When the iterative solution technique is performed using such a distributed memory parallel computing apparatus, a series of calculating processes are performed for each processor so as to calculate an approximate solution vector and a partial norm. The partial norm is transmitted on a reduction transmission, which is transmission among processors. Then, a norm is calculated for each processor and a convergence-determination is performed by a comparison with the predetermined convergence-determination threshold value "ε".

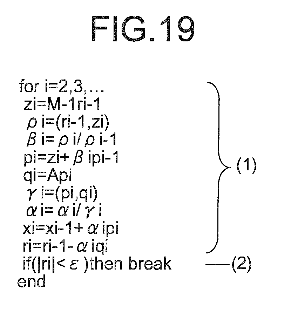

Furthermore, for example, when a conjugate gradient method with preprocessing is performed using the distributed memory parallel computing apparatus, the approximate solution vector and the residual vector "ri" corresponding to the approximate solution vector are calculated using the algorithm illustrated in (1) in FIG. 19. The partial norm is calculated using the algorithm illustrated in (2) in FIG. 19 so as to calculate the norm "|ri|". Then, a convergence-determination is performed by comparing the norm with the convergence-determination threshold value "ε". FIG. 19 illustrates an algorithm in accordance with conventional technology. In FIG. 19, "αi, βi, γi, and ρi" are scalar variables, "pi, qi, ri, xi, and zi" are vector variables, A and M⁻¹ (i.e., M inverse) are constant matrixes, and ε is a scalar constant.

Patent Document 1: Japanese Laid-open Patent Publication No. 2002-288147
Nonpatent Document 1: Richard Barrett and nine other authors, Templates for Iterative Methods, Translated by Satomi Hasegawa and two other translators, Asakura Publishing Co., Ltd., 1996
Nonpatent Document 2: Richard Barrett and nine other authors, Templates for the Solution Linear Systems: Building Blocks for Iterative Methods, searched online on the Internet on April. 18, 2006, URL: http://www.netlib.org/templates/templates.pdf

### DISCLOSURE OF INVENTION

### PROBLEM TO BE SOLVED BY THE INVENTION

There is a problem in the above-mentioned conventional technology in that the calculating processes with the iterative solution technique take a long period of time.

Specifically, in the distributed memory parallel computing apparatus, a calculating process such as a unit process in a floating-point calculation takes one nanosecond or less while latency (i.e., transmission time and execution time) in the reduction transmission is several microseconds, and the next iteration is performed after the convergence-determination. As a result, a long period of time is taken as transmission overhead, which is the amount of load caused by the reduction transmission in the summation calculation performed for the convergence-determination, compared with the period of time for an iteration.

Furthermore, when the distributed memory parallel computing apparatus includes many processors, the calculation amount for each processor decreases. Therefore, processing time for calculations is short while the latency in the reduction transmission is long due to the increasing in the number of processors. As a result, a long period of time is taken as transmission overhead compared with the processing time taken for calculation in each processor.

Furthermore, when the distributed memory computing apparatus uses an iteration solution technique for large-scale linear simultaneous equations, it is highly likely that the norm is determined to be equal to or higher than the convergence-determination threshold value, and therefore a series of calculating processes are repeatedly performed at least several dozen times. As a result, a long period of time is taken as transmission overhead compared with processing time for calculations to obtain a solution vector with use of the iterative solution technique.

The present invention is made in order to solve the above-mentioned problems in the conventional technology. An object of the present invention is to provide a computer apparatus, a calculation method, and a calculation program in which the transmission overhead is concealed and the calculating processes with the iterative solution technique can be performed in a short period of time.

### MEANS FOR SOLVING PROBLEM

To solve the problems described above and achieve the object, the invention as set forth in claim 1 is a computer apparatus for sharing calculating processes with a plurality of computer apparatuses that are connected with each other via a transmission unit, determining a significance of a calculation result calculated by the computer apparatus itself using calculation results calculated by other calculation processors, and performing repeatedly the calculating processes until the calculation result is determined to be significant. The computer apparatus includes an iterative calculation unit that, after its own calculation result is calculated with the calculating processes, does not wait for a determination as to whether the calculation result is significant but does repeatedly perform the calculating processes; a significance determining unit that, after the calculating processes are started by the iterative calculation unit and when the significance can be determined because of reception of calculation results from other computer apparatuses via the transmission unit, determines whether its own calculation result is significant; and a suspension unit that, when the calculation result is determined to be significant by the significance determining unit, suspends the calculating processes performed by the iterative calculation unit.

In the invention as set forth in claim 2, the iterative calculation unit repeatedly calculates, in the calculating processes, a solution vector of linear simultaneous equations.

In the invention as set forth in claim 3, the significance determining unit determines the significance, after the calculating processes are started by the iterative calculation unit and when an indication that the significance can be determined is transmitted from the transmission unit.

In the invention as set forth in claim 4, the significance determining unit sends, after the calculating processes are started by the iterative calculation unit, a request as to whether the significance can be determined to the transmission unit, and determines the significance when an indication that the significance can be determined is received as a result of the request.

In the invention as set forth in claim 5, the significance determining unit sends a request as to whether the significance can be determined to the transmission unit at predetermined progress intervals of the calculating processes.

The invention as set forth in claim 6 is a calculation method for performing calculating processes shared among a plurality of computer apparatuses that are connected with each other via a transmission unit, determining a significance of a calculation result calculated by a computer apparatus itself using calculation results calculated by other calculation processors, and performing repeatedly the calculating processes until the calculation result is determined to be significant. The calculation method includes an iterative calculation step of repeatedly performing the calculating processes without waiting for a determination as to whether the calculation result is significant, after its own calculation result is calculated with the calculating processes; a significance determining step of determining whether its own calculation result is significant after the calculating processes are started at the iterative calculation step and when the significance can be determined because of reception of calculation results from other computer apparatuses via the transmission unit; and a suspension step of suspending the calculating processes performed at the iterative calculation step, when the calculation result is determined to be significant at the significance determining step.

The invention as set forth in claim 7 is a calculation program for causing a computer to execute a calculation method for performing calculating processes shared among a plurality of computer apparatuses that are connected with each other via a transmission unit, determining a significance of a calculation result calculated by a computer apparatus itself using calculation results calculated by other calculation processors, and performing repeatedly the calculating processes until the calculation result is determined to be significant. The calculation program causes the computer to execute: an iterative calculation step of repeatedly performing the calculating processes without waiting for a determination as to whether the calculation result is significant, after its own calculation result is calculated with the calculating processes; a significance determining step of determining whether its own calculation result is significant after the calculating processes are started at the iterative calculation step and when the significance can be determined because of reception of calculation results from other computer apparatuses via the transmission unit; and a suspension step of suspending the calculating processes performed at the iterative calculation step, when the calculation result is determined to be significant at the significance determining step.

### EFFECT OF THE INVENTION

According to the inventions in claims 1, 6, and 7, after its own calculation result is calculated with the calculating processes, calculating processes are repeatedly executed without waiting for a determination as to whether the calculation result is significant. After the calculating processes are started and when an indication that the significance can be determined is transmitted because of reception of calculation results from other computer apparatuses via transmission units, the significance of its own calculation result is determined. When it is determined that the calculation result is significant, the calculating processes are suspended. Therefore, transmission overhead can be concealed, and the calculating processes with the iterative solution technique can be performed in a short period of time.

Furthermore, according to the invention in claim 2, the solution vector of linear simultaneous equations is repeatedly calculated with calculating processes. Therefore, the transmission overhead in the summation calculation can be concealed, and the solution vector with linear simultaneous equations can be calculated in a short period of time.

Furthermore, according to the invention in claim 3, after the calculating processes are started and when an indication that the significance can be determined is transmitted from the transmission unit, the significance is determined. Therefore, the transmission overhead can be concealed because of an interruption signal indicating that the significance can be determined, and the calculating processes with the iterative solution technique can be performed in a short period of time.

Furthermore, according to the invention in claim 4, after the calculating processes are started and when a request as to whether the significance can be determined is sent to the transmission unit and when an indication that the significance can be determined is received as a result of the request, the significance is determined. The transmission overhead can be concealed because of a request as to whether the significance can be determined, and the calculating processes with the iterative solution technique can be performed in a shorter period of time.

Furthermore, according to the invention in claim 5, an indication that the significance can be determined is sent to the transmission unit at predetermined progress intervals of the calculating processes. Thus, a residual norm is requested for each calculation pattern and the approximate solution vector is calculated. Therefore, the transmission overhead is concealed, and the calculating processes with the iterative solution technique can be performed in a shorter period of time.

### BRIEF DESCRIPTION OF DRAWINGS

FIG. 1 is an explanatory diagram illustrating an outline and features of a computer system in accordance with a first embodiment.
FIG. 2 is an explanatory diagram illustrating time features in accordance with the first embodiment.
FIG. 3 is a block diagram illustrating a configuration of a processor in accordance with the first embodiment.
FIG. 4 is an example of information stored in an other-processor partial-norm storage unit in a processor 1.
FIG. 5 is a flowchart illustrating a flow of a series of calculating processes in an iterative calculation unit in accordance with the first embodiment.
FIG. 6 is a flowchart illustrating a flow of series of calculating processes in the iterative calculation unit receiving a suspension signal in accordance with the first embodiment.
FIG. 7 is a flowchart illustrating a flow of processes in a solution determining unit in accordance with the first embodiment.
FIG. 8 is a flowchart illustrating a flow of processes in an other-processor-side input/output processing unit receiving a partial norm from other processors in accordance with the first embodiment.
FIG. 9 is a flowchart illustrating a flow of processes in a summation calculation unit in accordance with the first embodiment.
FIG. 10 is a diagram illustrating an algorithm in the computer system in accordance with the first embodiment.
FIG. 11 is an explanatory diagram illustrating effects of the computer system in accordance with the first embodiment.
FIG. 12 is an explanatory diagram illustrating an outline and features in accordance with a second embodiment.
FIG. 13 is a flowchart illustrating a flow of processes in an iterative calculation unit in accordance with the second embodiment.
FIG. 14 is a flowchart illustrating a flow of processes in a solution determining unit in accordance with the second embodiment.
FIG. 15 is a flowchart illustrating a flow of processes in a summation calculation unit in accordance with the second embodiment.
FIG. 16 is a diagram illustrating an algorithm in the computer system in accordance with the second embodiment.
FIG. 17 is a diagram illustrating an algorithm in a computer system in accordance with a third embodiment.
FIG. 18 is a diagram illustrating a computer for executing calculation programs.
FIG. 19 is a diagram illustrating an algorithm in accordance with conventional technology.

### EXPLANATIONS OF LETTERS OR NUMERALS

- 10: Processor
- 20: Main operation unit
- 21: Processing unit
- 22: Storage unit
- 23: Approximate-solution-vector register
- 24: Partial-norm register
- 25: Iterative calculation unit
- 26: Solution determining unit
- 30: Reduction transmission unit
- 31: Processing unit
- 32: Storage unit
- 33: Summation-calculation-result register
- 34: Other-processor partial-norm storage unit
- 35: Summation calculation unit
- 36: Other-processor-side input/output processing unit
- 37: Calculation-termination-flag register

### BEST MODE(S) FOR CARRYING OUT THE INVENTION

### First Embodiment

In a first embodiment described below, an outline and features of a computer system, a configuration of processors, a flow of processes in a computer system in accordance with the first embodiment are described in order and, finally, the effects of the first embodiment are described.

### Outline and Features of Computer System in accordance with First Embodiment

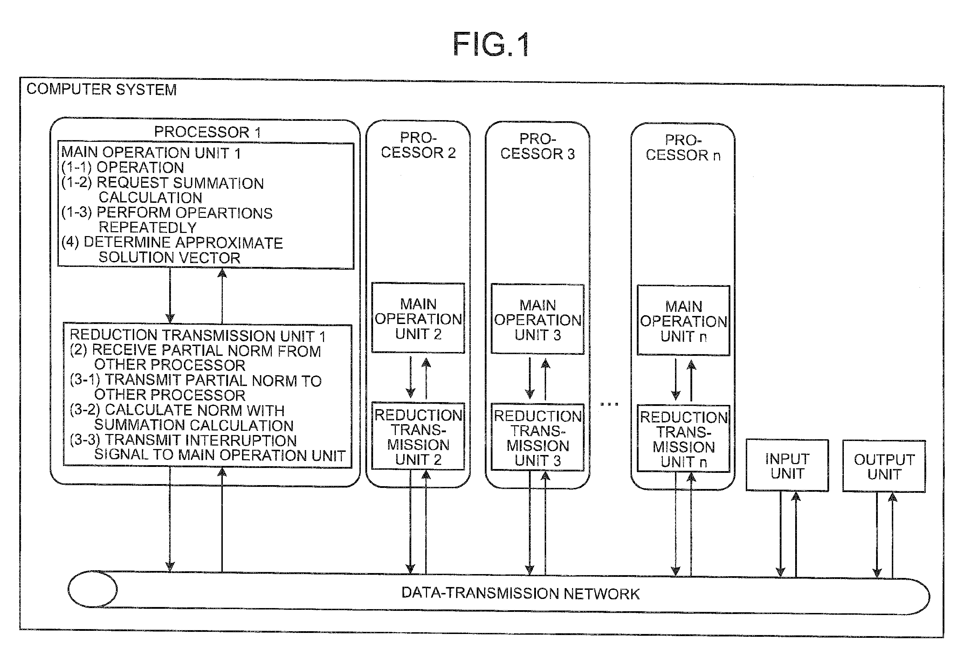

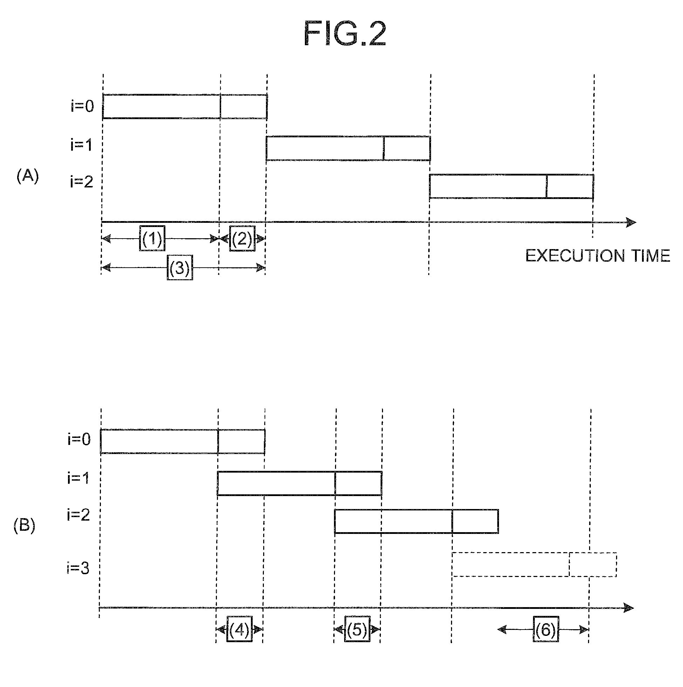

Firstly, an outline and features of a computer system in accordance with a first embodiment are described with reference to FIGS. 1 and 2. FIG. 1 is an explanatory diagram illustrating an outline and features of a computer system in accordance with the first embodiment. FIG. 2 is an explanatory diagram illustrating time features of a computer system in accordance with the first embodiment.

As illustrated in FIG. 1, the computer system in accordance with the first embodiment includes main operation units (main operation units 1 to n), reduction transmission units (reduction transmission units 1 to n), and processors (processors 1 to n) and also includes processors, an input unit and an output unit that are connected on a data-transmission network. The computer system performs a series of calculations in each processor so as to obtain a solution.

Specifically, the computer system performs a series of calculating processes in each processor, so as to repeatedly calculate the approximate solution vector "xi" (which represents x corresponding to i) and the partial norm using "matrix A" and "vector b". The computer system transmits the partial norm among the processors and performs a summation calculation on the partial norms so as to calculate a norm that indicates the accuracy of the approximate solution vector. Furthermore, when a "norm" is equal to or higher than a predetermined convergence-determination threshold value "ε", the computer system repeatedly performs a series of calculating processes. When the "norm" is lower than the predetermined convergence-determination threshold value "ε", the computer system performs a convergence-determination, determining the calculated approximate solution vector "xi" as the solution vector "x". Thus, the computer system calculates the solution vector "x" converged at sufficient accuracy. As described as the outline, the main features of the computer system in accordance with the first embodiment are that the computer system conceals transmission overhead and performs calculating processes with use of the iterative solution technique in a short period of time.

The main features are described below. After its own calculation result is calculated with calculating processes, the computer system in accordance with the first embodiment does wait for a determination as to whether a calculation result is significant but repeatedly perform calculating processes. Specifically, as illustrated in (1-1) in FIG. 1, the main operation unit in each processor performs a series of calculating processes so as to obtain the approximate solution and the partial norm. As illustrated in (1-2) in FIG. 1, the main operation unit requests a summation calculation of the partial norms to a reduction transmission unit. Then, as illustrated in (1-3) in FIG. 1, the main operation unit repeatedly performs a series of calculating processes, and thus starts a calculation of a new approximate solution vector and partial norm.

As illustrated in (2) in FIG. 1, the reduction transmission unit in each processor is ready to receive the partial norm from other processors. When the reduction transmission unit receives a request for the summation calculation from each main operation unit as illustrated in (3-1) in FIG. 1, the partial norm calculated by the main operation unit in its own processor is transmitted to other processors. When the reduction transmission unit receives the partial norms from all the other processors as illustrated in (3-2) in FIG. 1, the reduction transmission unit calculates a norm by performing the summation calculation on the partial norms. Then, as illustrated in (3-3) in FIG. 1, the reduction transmission unit transmits an interruption signal to the main operation unit in its own processor, thereby notifying the main operation unit that the summation calculation is terminated.

When calculation results are received from other computer apparatuses and thus it can be determined whether the calculation result is significant, the computer system in accordance with the first embodiment determines whether its own calculation result is significant. When it is determined that the calculation result is significant, the calculating processes are suspended. Specifically, as illustrated in (4) in FIG. 1, the main operation unit receiving an interruption signal compares the norm calculated by the reduction transmission unit in its own processor with a convergence-determination threshold value and thus determines whether the calculated approximate solution vector is significant. When the norm is lower than the convergence-determination threshold value, a series of calculating processes repeatedly performed are suspended.

As described above, with the above-mentioned main features, the computer system in accordance with the first embodiment can conceal transmission overhead and perform calculating processes with use of the iterative solution technique in a short period of time. As illustrated in (A) in FIG. 2, the sum, of the calculation time (see (1) of (A) in FIG. 2) taken for calculating the approximate solution vector and the partial norms, and time (see (2) of (A) in FIG. 2) taken for the reduction transmission to perform the summation calculation on the partial norms, is the calculation time (see (3) of (A) in FIG. 2) taken for one iteration (i = 0,1,2). However, the computer system in accordance with the first embodiment starts a series of calculating processes while the reduction transmission is performed, so that the overhead is concealed (see (4) and (5) of (B) in FIG. 2) in each iteration and therefore the calculating processes with the iteration solution technique can be performed in a short period of time (see (6) of (B) in FIG. 2).

### Configuration of Processors in accordance with First Embodiment

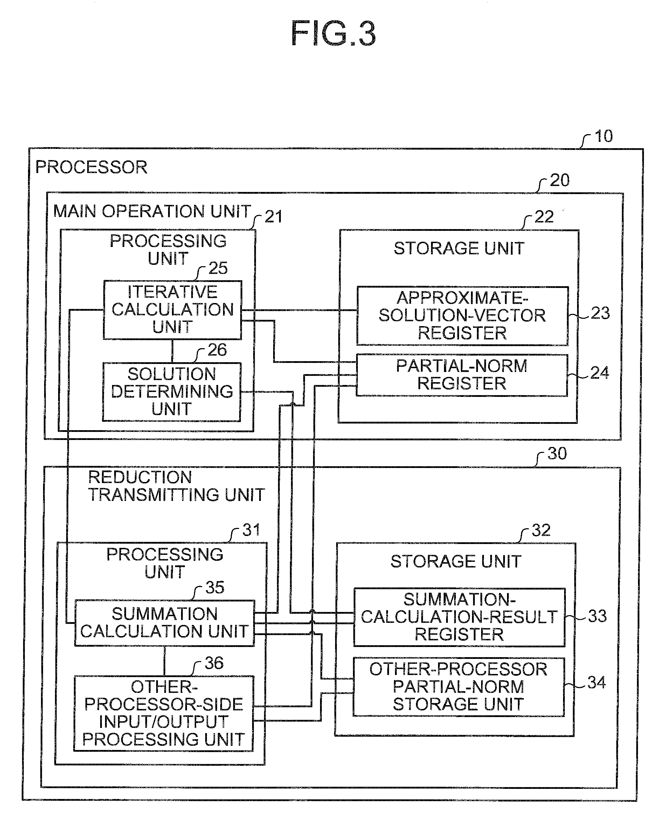

A configuration of processors in accordance with the first embodiment is described with reference to FIG. 3. FIG. 3 is a block diagram illustrating a configuration of a processor in accordance with a first embodiment. As illustrated in FIG. 3, a processor 10 includes a main operation unit 20 and a reduction transmission unit 30.

The main operation unit 20 includes a memory for storing algorithms that define various calculating processes and thus the main operation unit 20 can perform the various calculating processes. As illustrated in FIG. 3, in close relation with the present invention, the main operation unit 20 includes a processing unit 21 and a storage unit 22.

The storage unit 22 in the main operation unit 20, temporarily or for a long period of time, stores therein information for processing data. In close relation with the present invention, as illustrated in FIG. 3, the main operation unit 20 includes an approximate-solution-vector register 23 and a partial-norm register 24.

The approximate-solution-vector register 23 stores calculation results calculated with a series of calculating processes. Specifically, for example, the approximate-solution-vector register 23 stores therein the approximate solution vector "xi" calculated with a series of calculating processes and is overwritten every time a series of calculating processes are repeated by an iterative calculation unit 25, which is described later.

The partial-norm register 24 stores therein the partial norms calculated with a series of calculating processes. Specifically, for example, the partial-norm register 24 stores therein a series of calculating processes and is overwritten every time a series of calculating processes are repeated by the iterative calculation unit 25 described later.

The processing unit 21 in the main operation unit 20 includes an internal memory for storing programs and control data defining various procedures and thus the processing unit 21 can perform the various processes. Particularly in close relation with the present invention, the processing unit 21 includes the iterative calculation unit 25 and a solution determining unit 26. The iterative calculation unit 25 corresponds to the "iterative calculation unit" described in claims, and the solution determining unit 26 corresponds to the "significance determining unit" and the "suspension unit" described in claims.

After its own calculation result is calculated with calculating processes, the iterative calculation unit 25 does not wait for a determination as to whether a calculation result is significant but repeatedly perform calculating processes. Specifically, for example, when "matrix A" data (e.g., when car collision simulations are to be performed, data calculated based on the shape) is input, the iterative calculation unit 25 calculates the approximate solution vector with a series of calculating processes and overwrites the approximate-solution-vector register 23. Moreover, the iterative calculation unit 25 calculates the partial norm and overwrites the partial-norm register 24. Furthermore, the iterative calculation unit 25 requests a summation calculation of the partial norms to the reduction transmission unit 30. The iterative calculation unit 25 starts a calculation of a new approximate solution vector by repeatedly performing a series of calculating processes. When a suspension signal of calculating processes is received from the solution determining unit 26, the iterative calculation unit 25 suspends the calculating processes that are repeatedly performed, reads out the approximate solution vector from the approximate-solution-vector register 23, and outputs the approximate solution vector as the solution vector.

After the calculating processes are started by the iterative calculation unit 25 and when the reduction transmission unit 30 receives calculation results from other computer apparatuses and significance can be determined, the solution determining unit 26 determines whether its own calculation result is significant. Specifically, for example, when the solution determining unit 26 receives an interruption signal from a summation calculation unit 35 described later, the solution determining unit 26 reads the norm from a summation-calculation-result register 33 described later, compares the norm with the convergence-determination threshold value, and thus determines whether the calculated approximate solution vector is significant. When the norm is lower than the convergence-determination threshold value, an interruption signal of calculating processes is transmitted to the iterative calculation unit 25.

The reduction transmission unit 30 includes a memory for storing algorithms that define various processes and thus the reduction transmission unit 30 performs various processes. In close relation with the present invention, as illustrated in FIG. 3, the reduction transmission unit 30 includes a processing unit 31 and a storage unit 32.

The storage unit 32 in the reduction transmission unit 30, temporarily or for a long period of time, stores therein information for processing data. In close relation with the present invention, as illustrated in FIG. 3, the storage unit 32 includes the summation-calculation-result register 33 and an other-processor partial-norm storage unit 34.

The summation-calculation-result register 33 stores therein calculation results calculated with the summation calculation. Specifically, for example, the summation-calculation-result register 33 stores therein the norm calculated with the summation calculation and is overwritten by the summation calculation unit 35 described later.

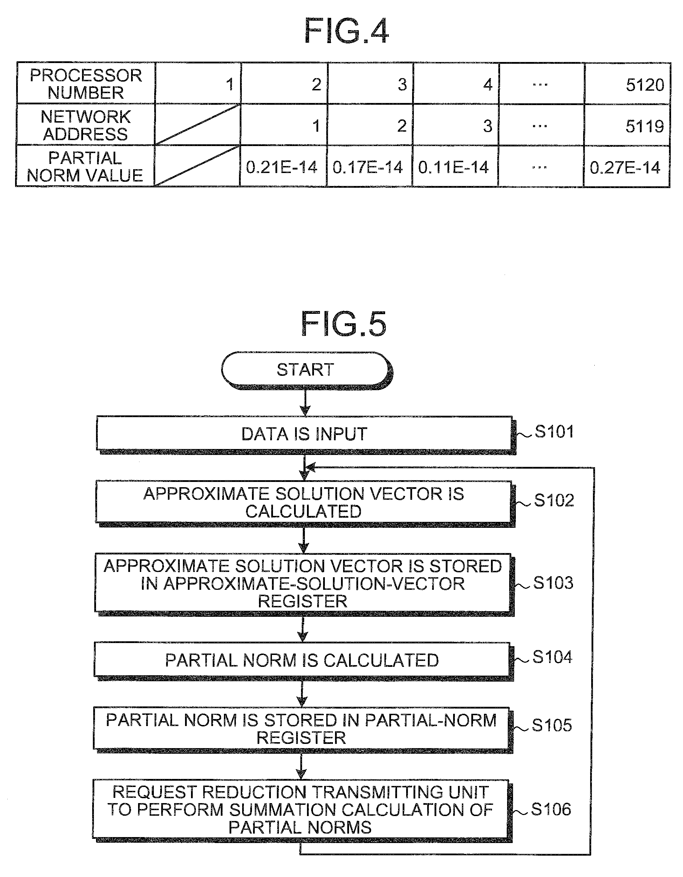

The other-processor partial-norm storage unit 34 stores therein calculation results calculated by other processors. Specifically, for example, the other-processor partial-norm storage unit 34 stores therein a processor number that is previously attached to each processor, a network address of each processor, and a partial norm calculated by each processor, in association with each other. For example, as illustrated in FIG. 4, the other-processor partial-norm storage unit 34 stores the partial norm "0.21E-14" (i.e., a value, 0.21 times 10 raised to minus 14th power) calculated by "a processor 2 whose network address is one". FIG. 4 illustrates an example of information stored in the other-processor partial-norm storage unit in the processor 1. The partial norm is overwritten by an other-processor-side input/output processing unit 36 described later.

The processing unit 31 in the reduction transmission unit 30 includes an internal memory for storing control data and programs that define various procedures, and thus the processing unit 31 performs various processes. Particularly in close relation with the present invention, the processing unit includes the summation calculation unit 35 and the other-processor-side input/output processing unit 36.

The summation calculation unit 35 calculates a determination value that is used for determining whether its own calculation result is significant. Specifically, for example, the summation calculation unit 35 receives a summation-calculation request of the partial norm from the iterative calculation unit 25, reads the partial norm from the partial-norm register 24, and transmits the partial norm to the other processors via the other-processor-side input/output processing unit 36. When the partial norms received from all the other processors are stored in the other-processor partial-norm storage unit 34, the summation calculation unit reads the partial norms from the partial-norm register 24 and the other-processor partial-norm storage unit 34 and calculates summation of the partial norms, and thus the norm is calculated. Furthermore, the summation calculation unit 35 stores the norm in the summation-calculation-result register 33 and transmits an interruption signal to the solution determining unit 26.

The other-processor-side input/output processing unit 36 performs input/output processes among other processors. Specifically, for example, when the partial norm is received from the summation calculation unit 35, the other-processor-side input/output processing unit 36 transmits the partial norm to all the other processors. Furthermore, when the partial norm is received from other processors, the other-processor-side input/output processing unit 36 stores the norm in the other-processor partial-norm storage unit 34 in association with the processor number and the network address of the transmission side. For example, when the partial norm is received from the processor 2 whose network address is one, the partial norm is stored in the entry whose processor number is two and whose network address is one.

### Processes in Computer System in accordance with First Embodiment

A flow of processes in the computer system in accordance with the first embodiment are described with reference to FIGS. 5 to 10. Specifically, a series of calculating processes in the iterative calculation unit 25, processes in the iterative calculation unit receiving a suspension signal, processes in the solution determining unit 26, processes in the other-processor-side input/output processing unit 36 receiving the partial norm from other processors, and processes in the summation calculation unit 35 are described in turn.

First, with reference to FIG. 5, the series of calculating processes in the iterative calculation unit 25 in accordance with the first embodiment are described. FIG. 5 is a flowchart illustrating a flow of a series of calculating processes in the iterative calculation unit 25 in accordance with the first embodiment.

When "matrix A" data is input as illustrated in FIG. 5 (Step S101), the iterative calculation unit 25 calculates the approximate solution vector with the series of calculating processes (Step S102) and then stores the approximate solution vector in the approximate-solution-vector register 23 (Step S103).

The iterative calculation unit 25 calculates the partial norm (Step S104), stores the partial norm in the partial-norm register 24 (Step S105), requests a summation calculation on the partial norms to the reduction transmission unit 30 (Step S106), and starts the calculation of the approximate solution vector again (Step S102). As described, the iterative calculation unit 25 repeatedly performs the calculating processes until the suspension signal of the calculation processes is received from the solution determining unit 26 (Steps S102 to S106).

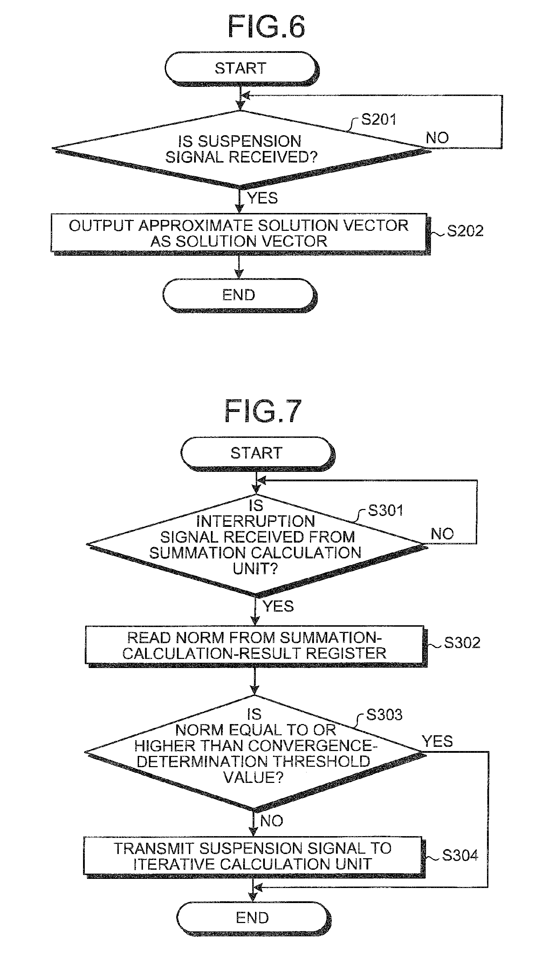

A flow of processes in the iterative calculation unit 25 receiving a suspension signal in accordance with the first embodiment is described with reference to FIG. 6. FIG. 6 is a flowchart illustrating a flow of series of calculating processes in an iterative calculation unit receiving a suspension signal in accordance with the first embodiment.

When the iterative calculation unit 25 receives a suspension signal of calculating processes from the solution determining unit 26 (Step S201: Yes), the iterative calculation unit 25 reads the approximate solution vector, outputs the same as the solution vector (Step S202), and terminates the processes in the whole computer system.

A flow of processes in the solution determining unit 26 in accordance with the first embodiment is described with reference to FIG. 7. FIG. 7 is a flowchart illustrating a flow of processes in the solution determining unit 26 in accordance with the first embodiment.

When an interruption signal is received from the summation calculation unit 35 as illustrated in FIG. 7 (Step S301: Yes), the solution determining unit 26 reads the norm from the summation-calculation-result register 33 (Step S302), and compares the norm with the convergence-determination threshold value. When it is determined that the norm is equal to or higher than the convergence-determination threshold value (Step S303: Yes), the solution determining unit 26 terminates the above-mentioned processes (Steps S301 to S303) and waits for an interruption signal again (Step S301).

When it is determines that the norm is lower than the convergence-determination threshold value (Step S303: No), the solution determining unit 26 transmits a suspension signal of calculating processes to the iterative calculation unit 25 (Step S304) and terminates the above-mentioned processes (Steps S301 to S304).

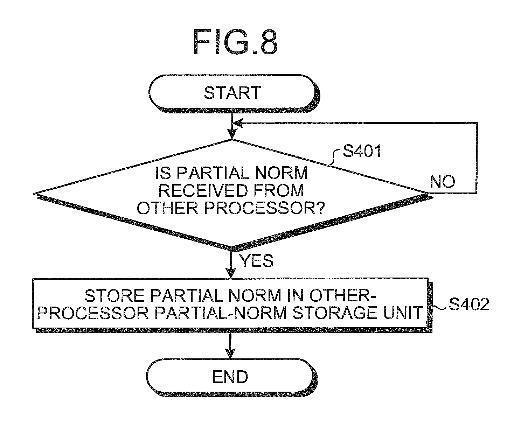

A flow of processes in the other-processor-side input/output processing unit receiving the partial norms from other processors in accordance with the first embodiment is described with reference to FIG. 8. FIG. 8 is a flowchart illustrating a flow of processes in an other-processor-side input/output processing unit receiving a partial norm from other processors in accordance with the first embodiment.

When the other-processor-side input/output processing unit 36 receives a partial norm from other processors as illustrated in FIG. 8 (Step S401: Yes), the other-processor-side input/output processing unit 36 stores the partial norm in the other-processor partial-norm storage unit 34 in association with a processor number and a network address (Step S402), terminates the above-mentioned processes, and waits for a partial norm from other processors again (Step S401).

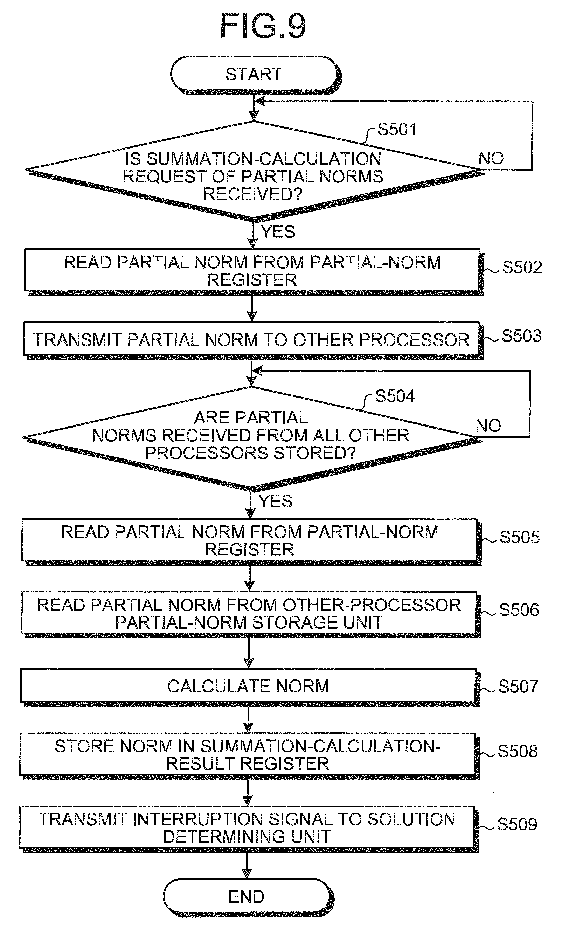

A flow of processes in the summation calculation unit 35 in accordance with the first embodiment is described with reference to FIG. 9. FIG. 9 is a flowchart illustrating a flow of processes in a summation calculation unit in accordance with the first embodiment.

When the summation calculation unit 35 receives a summation-calculation request of the partial norms from the iterative calculation unit 25 as illustrated in FIG. 9 (Step S501: Yes), the summation calculation unit 35 reads the partial norms from the partial-norm register 24 (Step S502), transmits the partial norm to other processors via the other-processor-side input/output processing unit 36 (Step S503), and waits until the partial norms from all the other processors are stored in the other-processor partial-norm storage unit 34 (Step S504: No).

When it is confirmed that the partial norms received from all the other processors are stored in the other-processor partial-norm storage unit 34 (Step S504: Yes), the summation calculation unit 35 reads the partial norm calculated by its own processor from the partial-norm register 24 (Step S505), reads the partial norms calculated by other processors from the other-processor partial-norm storage unit 34 (Step S506), and calculates the summation of the partial norms, and thereby calculating the norm (Step 5507).

The summation calculation unit 35 stores the norm in the summation-calculation-result register 33 (Step S508), and transmits an interruption signal to the solution determining unit 26 (Step S509), terminates the above-mentioned processes, and waits for a summation-calculation request of the partial norms again (Step S501).

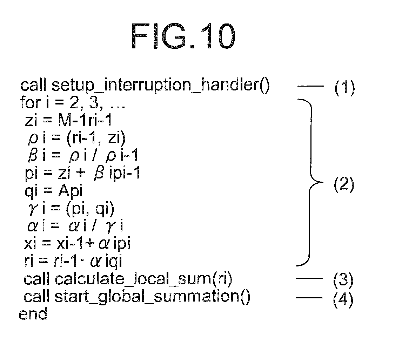

A flow of processes in the computer system in accordance with the first embodiment is described with reference to FIG. 10. FIG. 10 is a diagram illustrating an algorithm in the computer system in accordance with the first embodiment. In FIG. 10, "αi, βi, γi, and ρi"' are scalar variables, "pi, qi, ri, xi, and zi" are vector variables, "A and M⁻¹ (i.e., M inverse)" are constant matrixes, and "ε" is a scalar constant.

The computer system in accordance with the first embodiment waits for an interruption with use of the algorithm illustrated in (1) in FIG. 10 and performs a series of calculating processes with use of the algorithm illustrated in (2) in FIG. 10. The computer system in accordance with the first embodiment calculates the partial norm with use of the algorithm illustrated in (3) in FIG. 10, calculates the norm with use of the algorithm illustrated in (4) in FIG. 10, and determines whether the calculated approximate solution vector is significant. When it is determined that the approximate solution vector is significant, the computer system suspends the series of calculating processes.

### Effects of First Embodiment

As described above, in the first embodiment, after its own calculation result is calculated with calculating processes, calculating processes are repeatedly performed without waiting for determination as to whether the calculation result is significant. After the calculating processes are started and when the reduction transmission unit 30 receives calculation results from other computer apparatuses, i.e., when it can be determined whether the calculation result is significant, it is determined whether its own calculation result is significant. When it is determined that the calculation result is significant, the calculating processes by the iterative calculation unit 20 are suspended. Therefore, the transmission overhead is concealed, and the calculating processes with use of the iterative solution technique can be performed in a short period of time.

In processing time for one iteration, the reduction transmission, which is involved in the summation calculation for a convergence-determination and takes a high ratio of the processing time for one iteration, is concealed, and, as a result, the calculating processes with the iterative solution technique can be performed in a short period of time. Furthermore, the reduction transmission for the summation calculation is concealed and the processing time taken for the reduction transmission takes a lower ratio of the processing time compared with the processing time taken for calculations, and, as a result, the calculating processes with the iterative solution technique can be performed efficiently in a short period of time. Furthermore, the reduction transmission for the summation calculation is repeatedly concealed, and, as a result, the calculating processes with the iterative solution technique can be performed in a shorter period of time, i.e., the processing time taken for calculating the solution vector with use of the iterative solution technique can be shorter.

Furthermore, according to the first embodiment, the calculating processes are performed so that the solution vector of the linear simultaneous equations is repeatedly calculated. Therefore, the transmission overhead for the summation calculation can be concealed and the solution vector of the linear simultaneous equations can be calculated in a short period of time.

Furthermore, according to the first embodiment, after the calculation processes are started and when a notification that the significance can be now determined is transmitted from the reduction transmission unit 30, the significance is determined. Therefore, the transmission overhead is concealed with the interruption signal indicating that the significance can be determined, and the calculating processes with the iterative solution technique can be performed in a short period of time.

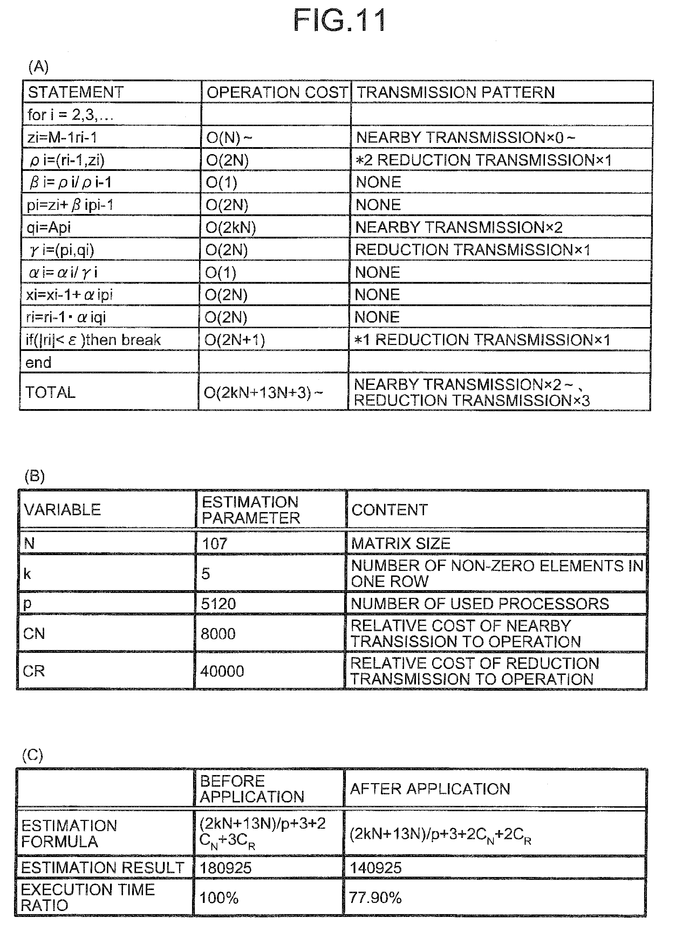

Effects of the computer system in accordance with the first embodiment are described with reference to FIG. 11. FIG. 1.1 is an explanatory diagram illustrating effects of a computer system in accordance with the first embodiment. In FIG. 11, (A) illustrates correspondences between operation cost and transmission pattern. For example, operation cost taken for "if (|ri| < ε) then break", which is a statement for the summation calculation on the norm, is "O(2N + 1)" while the transmission pattern thereof indicates that "one reduction transmission" is to be taken. Furthermore, in FIG. 11, the total in (A) indicates the operation cost and the transmission pattern taken for executing once an algorithm in accordance with conventional technology, i.e., for executing once a series of calculating processes. For example, the operation cost "O(1)" in (A) in FIG. 11 indicates the operation cost taken for executing once an operation such as multiplication, "NEARLY TRANSMISSION" indicates transmission processes with processors nearby, and "REDUCTION TRANSMISSION" indicates transmission processes with all the other processors.

In FIG. 11, (B) is an explanatory diagram illustrating estimation parameters and contents for variables. For example, the variable "p" indicates a computer system on which "5120 units" of processors, i.e., the number of used processors, are mounted (i.e., corresponds to n in FIG. 1). In FIG. 11, "N", "k", or "p" in (B) are exemplary matrixes or numerical values for a computer system, and CN and CR are exemplary numerical values indicating actual measurement values in the known distributed memory parallel computing apparatus. Furthermore, the estimation parameter "107" in the variable N indicates "10 raised to 7th power".

In FIG. 11, (C) illustrates an estimation formula for estimating processing costs, before the application of the present invention or after the application of the present invention, taken for a computer system with the "p" number of processors to perform a series of calculating processes. For example, in the estimation formula before the application, the total operation cost (with some parts excluded) illustrated in (A) in FIG. 11 is divided by the number of processors and then the relative cost of each transmission pattern is added. Furthermore, the estimation result and execution time ratio that are obtained by assigning estimation parameters to the variables illustrated in (B) in FIG. 11 are illustrated.

The computer system in accordance with the first embodiment provides an advantage in that the reduction transmission illustrated at "*1" in (A) in FIG. 11, i.e., the reduction transmission for the summation calculation, is concealed. The processing cost, taken for executing once a series of calculating processes, before the application of the present invention or after the application of the present invention, is calculated with the estimation formula in (C) in FIG. 11. According to the estimation result that is obtained, before or after the application of the present invention, by assigning the estimation parameters illustrated in (B) in FIG. 11 to the variables, the execution time ratio after the application of the present invention is "77.90%". As described, the computer system in accordance with the first embodiment can calculate the solution vector in "77.90%" time compared with the time before the application of the present invention.

### Second Embodiment

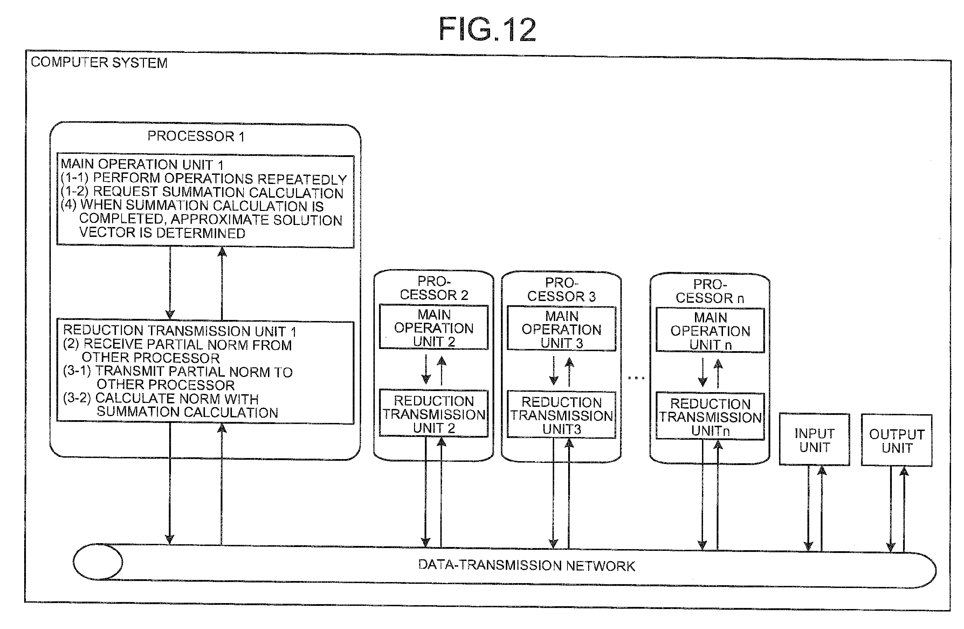

In the first embodiment above, the reduction transmission unit transmits an interruption signal to the main operation unit so as to notify that the summation calculation is terminated. However, the present invention is not limited to this. For example, the main operation unit may send to the reduction transmission unit a request as to whether the summation calculation is terminated. The following description describes as a second embodiment a case in which the main operation unit sends a request as to whether the summation calculation is terminated with reference to FIGS. 12 to 16.

### Outline and Features of Computer System in accordance with Second Embodiment

FIG. 12 is an explanatory diagram illustrating an outline and features in accordance with the second embodiment. As illustrated in FIG. 12, the features of the computer system in accordance with the second embodiment are that the computer system has the same configuration and outline as the computer system in accordance with the first embodiment and calculates the approximate solution vector without temporarily suspending the series of calculating processes, so that the transmission overhead can be concealed and the calculating processes with the iterative solution technique can be performed in a shorter period of time. Specifically, as illustrated in (1-1) in FIG. 11, the main operation unit in each processor repeatedly performs calculations and sends to a reduction transmitting apparatus a request as to whether the summation calculation is terminated. Then, as illustrated in (1-2) in FIG. 12, the main operation unit requests the reduction transmission unit for the summation calculation on the partial norms.

Similarly to the computer system in accordance with the first embodiment, the reduction transmission unit in each processor always receives the partial norms from other processors as illustrated in (2) in FIG. 12. When the reduction transmission unit receives a request for the summation calculation from each main operation unit, the reduction transmission unit transmits the partial norm calculated by the main operation unit in its own processor to other processors as illustrated in (3-1) in FIG. 12. Furthermore, after the reduction transmission unit receives the partial norms from all the other processors, the reduction transmission unit performs the summation calculation on the partial norms so as to calculate the norm as illustrated in (3-2) in FIG. 12.

When the computer system in accordance with the second embodiment obtains, as a result of a request, an indication that the significance can be determined, the computer system determines significance. Specifically, when the summation calculation turns out to be terminated as a result of requesting the reduction transmitting apparatus to terminate the summation calculation in (1-1) in FIG. 12, the approximate solution vector is determined as illustrated in (4) in FIG. 12.

As described, the above-described features of the computer system in accordance with the second embodiment are that the transmission overhead can be concealed by sending a request as to whether the significance can be determined, and the calculating processes with the iterative solution technique can be performed in a shorter period of time.

### Configuration of Computer System in accordance with Second Embodiment

Other than the storage unit 32 in the reduction transmission unit 30 including newly a calculation-termination-flag register 37, the computer system in accordance with the second embodiment has the same configuration as the computer system 10 illustrated in FIG. 3. Furthermore, other than the operation in the iterative calculation unit 25, the solution determining unit 26, the summation calculation unit 35, and the calculation-termination-flag register 37, the computer system is operated similarly. The calculation-termination-flag register 37 and the solution determining unit 26 are described below. The iterative calculation unit 25 and the summation calculation unit 35 are described in detail later.

The calculation-termination-flag register 37 stores therein a value indicating an execution state of each process. Specifically, for example, the calculation-termination-flag register 37 indicates that the calculation of the norm is finished, "1" for the solution determining unit 26 to start the determination of the significance, or indicates that the calculation of the norm is not finished and stores therein "0" for the solution determining unit 26 to be on a standby for the determination of the significance and is eventually overwritten by the summation calculation unit 35 or the solution determining unit 26.

The solution determining unit 26 sends to the reduction transmission unit 30 a request as to whether the significance can be determined. When the solution determining unit 26 obtains, as a result of the request, a response indicating that the significance can be determined, the solution determining unit 26 determines the significance. Specifically, for example, the solution determining unit 26 receives a request for referring to the calculation-termination-flag register 37 from the iterative calculation unit 25. When `°1'° for starting the determination of the significance is stored in the calculation-termination-flag register 37, the solution determining unit 26 reads the norm from the summation-calculation-result register 33. By comparing the norm with the convergence-determination threshold value, the solution determining unit 26 determines whether the calculated approximate solution vector is significant. When the norm is lower than the convergence-determination threshold value, a suspension signal of the calculating processes is transmitted to the iterative calculation unit 25. When the norm is equal to or higher than the convergence-determination threshold value, the solution determining unit 26 overwrites the calculation-termination-flag register 37 into "0" indicating it is on a standby for the determination of the significance and transmits to the iterative calculation unit 25 an indication that the determination of the approximate solution vector is finished.

### Processes in Computer System in accordance with Second Embodiment

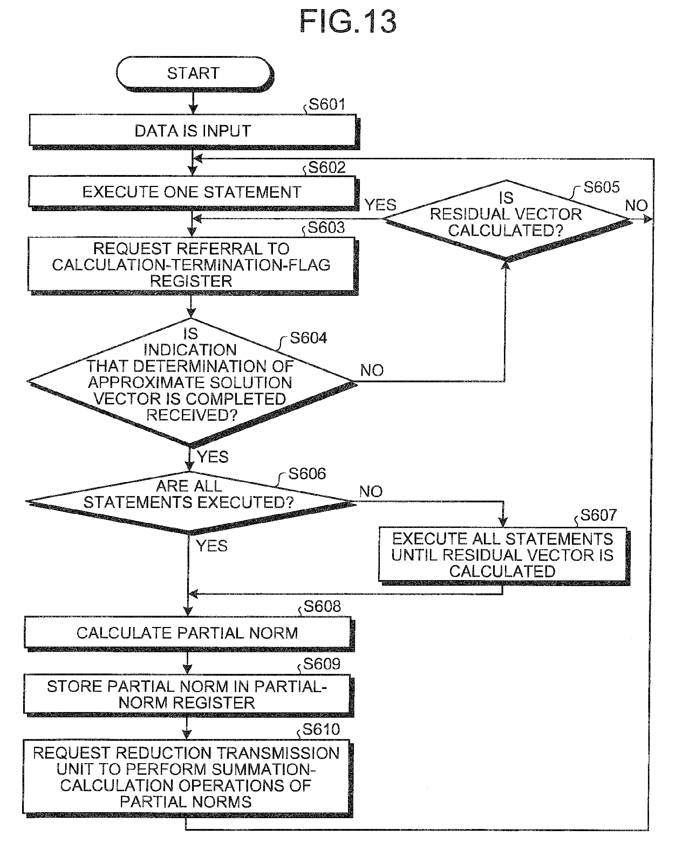

Processes in the iterative calculation unit in accordance with the second embodiment are described with reference to FIG. 13. FIG. 13 is a flowchart illustrating a flow of processes in an iterative calculation unit in accordance with the second embodiment.

When "matrix A" data is input (Step S601) as illustrated in FIG. 13, the iterative calculation unit 25 executes a statement (Step S602), and requests the solution determining unit 26 to refer to the calculation-termination-flag register 37 (Step S603). When an indication that the determination of the approximate solution vector is finished is not received from the solution determining unit 26 (Step S604: No) and further when the residual vector is not calculated (Step S605: No), the iterative calculation unit 25 continues to executes a statement and sends a request for referring to the calculation-termination-flag register until the residual vector is calculated (Steps S602 to S605). Furthermore, when the residual vector is calculated (Step S605: Yes), the iterative calculation unit only sends a request for referring to the calculation-termination-flag register and is on a standby for the calculation of the partial norm (Steps S603 to S605).

When an indication that the process is in a first calculating process or that the determination of the approximate solution vector is finished is received (Step S604: Yes), the iterative calculation unit 25 determines whether all the statements are executed to calculate the residual vector (Step S606). When all the statements are executed to calculate the residual vector, the partial norms are calculated (Step S606). When not all the statements are executed (Step S606: No), all the statements are executed to calculate the residual vector (Step S607) to calculate the partial norm (Step S608).

The iterative calculation unit 25 stores the partial norm in the partial-norm register 24 (Step S609), sends a request to the reduction transmission unit 30 for the summation calculation on the partial norms (Step S610), executes a statement again, and thus repeatedly executes calculating processes (Steps S602 to S610).

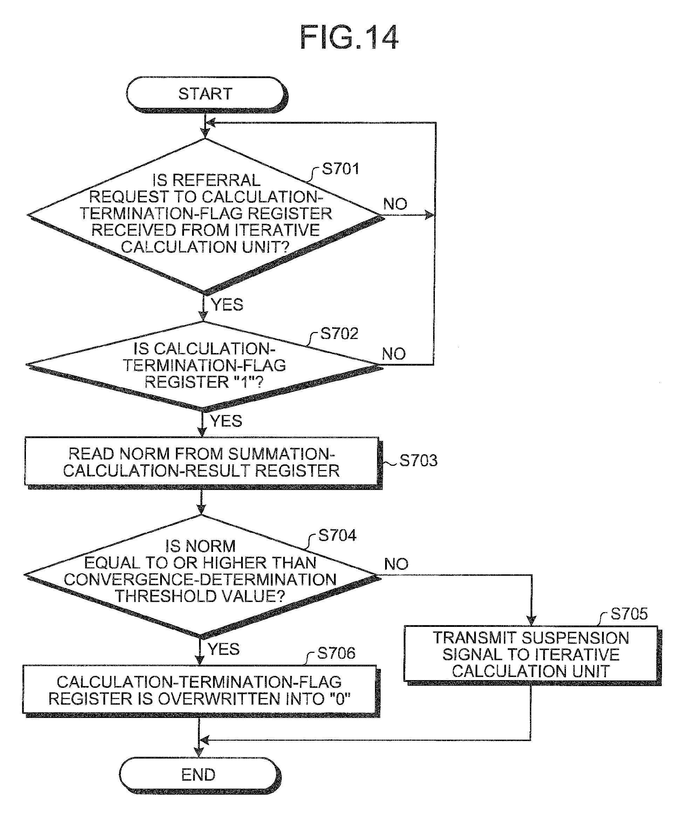

A flow of processes in the solution determining unit 26 in accordance with the second embodiment is described with reference to FIG. 14. FIG. 14 is a flowchart illustrating a flow of processes in a solution determining unit in accordance with the second embodiment.

When the solution determining unit 26 receives a request for referring to the calculation-termination-flag register 37 from the iterative calculation unit 25 as illustrated in FIG. 14 (Step S701: Yes), the solution determining unit 26 refers to the calculation-termination-flag register 37 (Step S702). When "1" is not stored in the calculation-termination-flag register 37 (Step S702: No), the solution determining unit 26 waits again for a request for referring to the calculation-termination-flag register 37 (Step S701).

When "1" is stored in the calculation-termination-flag register 37 (Step S702: Yes), the norm is read from the summation-calculation-result register 33 (Step S703). By comparing the norm with the convergence-determination threshold value, the solution determining unit 26 determines whether the calculated approximate solution vector is significant (Step S704).

When the norm is lower than the convergence-determination threshold value (Step S704: No), the solution determining unit 26 transmits to the iterative calculation unit 25 a suspension signal of the calculating processes (Step S705) and ends the above-mentioned processes (Steps S701 to Step S705).

When the norm is equal to or higher than the convergence-determination threshold value (Step S704: Yes), the solution determining unit 26 overwrites the calculation-termination-flag register 37 into "0" and transmits to the iterative calculation unit 25 an indication that the determination of the approximate solution vector is finished (Step S706). Then, the solution determining unit 26 ends the above-mentioned processes and waits again for a request for referring to the calculation-termination-flag register 37 (Step S701).

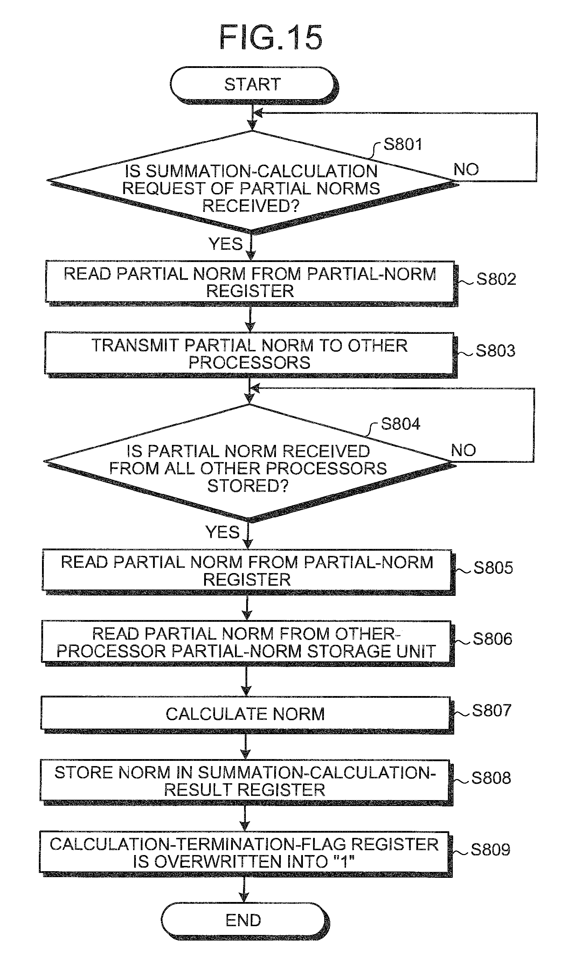

A flow of processes in the summation calculation unit 35 in accordance with the second embodiment is described with reference to FIG. 15. FIG. 15 is a flowchart illustrating a flow of processes in a summation calculation unit in accordance with the second embodiment.

As illustrated in FIG. 15, the summation calculation unit 35 receives a summation-calculation request of the partial norms from the iterative calculation unit 25 (Step S801: Yes), reads the partial norms from the partial-norm register 24 (Step S802), transmits the partial norms to the other processors via the other-processor-side input/output processing unit 36 (Step S803), and waits until the partial norms from all the other processors are stored in the other-processor partial-norm storage unit 34 (Step S804: No).

When it is confirmed that the partial norms from all the other processors are stored in the other-processor partial-norm storage unit 34 (Step S804: Yes), the summation calculation unit 35 reads the partial norm calculated by its own processor from the partial-norm register 24 (Step S805), reads the partial norms calculated by other processors from the other-processor partial-norm storage unit 34 (Step S806), and calculates the norm by calculating the summation of the partial norms (Step S807).

The summation calculation unit 35 stores the norm in the summation-calculation-result register 33 (Step S808), overwrites "1" into the calculation-termination-flag register 37 (Step S809), ends above-mentioned processes, and waits again for a summation-calculation request of the partial norms (Step S801).

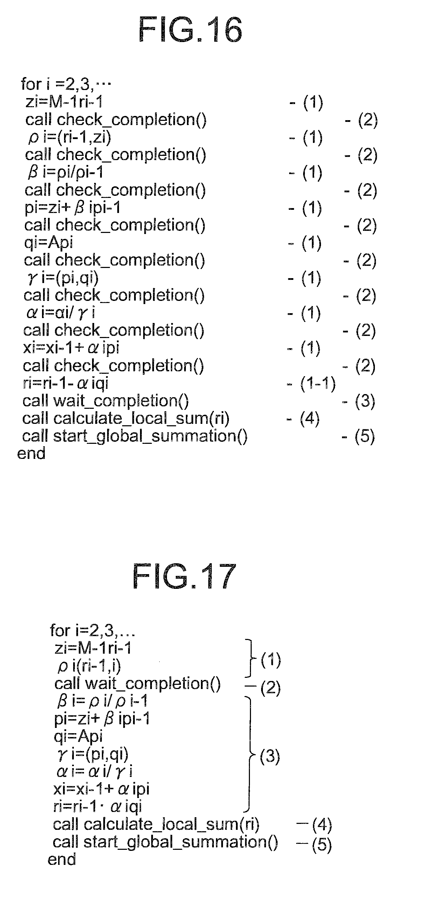

A flow of processes in the computer system in accordance with the second embodiment is described with reference to FIG. 16. FIG. 16 is a diagram illustrating an algorithm in a computer system in accordance with the second embodiment. The variables in FIG. 16 are agreeable with the variables illustrated in FIG. 10.

In the algorithm illustrated in (1), (1-1), (2), and (3) FIG. 16, the computer system in accordance with the second embodiment executes a statement of a series of calculating processes until the residual vector is calculated (see (1-1) in FIG. 16) and sends a request as to whether the significance can be determined (see (2) and (3) in FIG. 16). When receiving an indication that the significance can be determined as a result of the request, the computer system determines the approximate solution vector (see (2) and (3) in FIG. 16). When the norm is equal to or higher than the convergence-determination threshold value, the partial norm is calculated using the algorithm illustrated in (4) in FIG. 16. Then, the next norm is calculated using the algorithm illustrated in (5) in FIG. 16.

### Effects of Second Embodiment

As described, according to the second embodiment, after the calculating processes are started and when an indication that the significance can be determined is obtained as a result of sending to the reduction transmission unit 30 a request as to whether the significance can be determined, the significance is determined. Therefore, because of the request as to whether the significance can be determined, the transmission overhead is concealed and the calculating processes with the iterative solution technique can be performed in a shorter period of time.

Furthermore, according to the second embodiment, a request as to whether the significance can be determined is sent to the reduction transmission unit 30 at predetermined progress intervals of calculating processes. Therefore, the approximate solution vector is calculated with a request as to whether summation norms is sent for each calculation pattern. Thus, the transmission overhead is concealed and the calculating processes with the iterative solution technique can be performed in a shorter period of time.

Furthermore, according to the second embodiment, calculation results are calculated repeatedly and excessively by one time. Therefore, the calculating processes with the iterative solution technique can be performed without an increase in information to be stored.

### Third Embodiment

The above-mentioned second embodiment describes a case in which a request as to whether the significance can be determined at predetermined progress intervals of the calculating processes is sent to the reduction transmission unit 30. The request as to whether the significance can be determined may be sent to the reduction transmission unit 30 at every reduction transmission for a series of calculating processes. The following describes, as a third embodiment, a case in which a request as to whether the summation calculation is finished is sent every time the reduction transmission is to be performed in the calculating processes. Other than the different timings at which the iterative calculation unit 25 sends a request for referring to the calculation-termination-flag register 37, the third embodiment is the same as the above-mentioned second embodiment. Therefore, the detailed description on the processes in the computer system in accordance with the third embodiment is omitted below.

### Outline and Features of Computer System in accordance with Third Embodiment

The outline and the configuration of a computer system in accordance with the third embodiment are the same as the computer system in accordance with the first embodiment. The transmission overhead is concealed without sending requests to the reduction transmission unit more times than needed, and the calculating processes with the iterative solution technique are performed in a shorter period of time.

Specifically, for example, as illustrated in "*2" of (A) in FIG. 11, the reduction transmission is to be performed for the series of calculating processes. When processing time taken for the reduction transmission in accordance with "*2" is the same as processing time taken for the reduction transmission in accordance with "*1", the reduction transmission in accordance with "*1" is completed before the completion of the reduction transmission in accordance with "*2". That is, when the main operation unit refers to the calculation-termination-flag register after the completion of the reduction transmission in accordance with "*2", the summation calculation is definitely likely to have been completed. Therefore, the significance of its own calculation result can be determined, without referring to the calculation-termination-flag register more times than needed.

As described, the main features of the computer system in accordance with the third embodiment are that the transmission overhead is concealed without sending a request to the reduction transmission unit more times than needed, and the calculating processes with the iterative solution technique can be performed in a shorter period of time.

### Processes in Computer System in accordance with Third Embodiment

A flow of processes in the computer system in accordance with the third embodiment is described with reference to FIG. 17. FIG. 17 is a diagram illustrating an algorithm in a computer system in accordance with the third embodiment. The variables in FIG. 17 are agreeable with those in FIGS. 10 and 16.

The computer system in accordance with the third embodiment performs the series of calculating processes with the algorithm illustrated in (1) in FIG. 17. When the algorithm illustrated in (1) in FIG. 17 is completed, the computer system determines the approximate solution vector with the algorithm illustrated in (2) in FIG. 17. When the algorithm illustrated in (2) in FIG. 17 is completed, it is likely that the determination of the approximate solution vector is completed and therefore the approximate solution vector is determined with the algorithm illustrated in (2) in FIG. 17. When the norm is equal to or higher than the convergence-determination threshold value, the computer system continues to perform the series of calculating processes with the algorithm in (3) in FIG. 17, calculates the partial norms with the algorithm illustrated in (4) in FIG. 17, and calculates the next norm with the algorithm illustrated in (5) in FIG. 17.

### Effects of Third Embodiment

As described, according to the third embodiment, a request as to whether the significance can be determined is transmitted when transmission with other calculating apparatuses is to be performed upon performing the calculating processes. Therefore, the transmission overhead can be concealed without sending a request to the reduction transmission unit 30 more times than needed, and the calculating processes with the iterative solution technique can be performed in a shorter period of time.

### Fourth Embodiment

In the above description, embodiments of the present invention are described. Not limited to the embodiments described above, the present invention may be applied with other embodiments modified in various ways. The following describes the other embodiments as a fourth embodiment.

For example, in the first, second, and third embodiments, the solution vector is calculated using the conjugate gradient method with preprocessing. Not limited to this, the present invention may be applied to a case in which the solution vector is calculated with the iterative solution technique for performing a series of calculating processes (e.g., Jacobian method).

Furthermore, in the first, second, and third embodiments, the partial norm is calculated by the iterative calculation unit 25. The present invention is not limited to this, and the partial norm may be calculated by other processing units (e.g., the summation calculation unit 35).

### System Configurations and Others

Furthermore, procedures, control procedures, specific names, and information including various data and parameters (e.g., storage information illustrated in FIG. 4, and algorithms illustrated in FIGS. 10, 16, and 17) may be arbitrarily modified except as otherwise provided.

Furthermore, the components of the computer system illustrated in the drawings are merely functional concepts, and the physical configurations of these components are not necessarily the same as those illustrated. Therefore, specific integration/disintegration of the apparatuses are not limited to those illustrated. Depending on various load or operation statuses, all or some of the apparatuses may be functionally or physically integrated/disintegrated into an arbitrary unit (e.g., the solution determining unit 26 may be integrated into the processing unit 31 in the reduction transmission unit 30). Furthermore, all or some part of the processing functions in the apparatuses may be realized with a CPU and programs that are analyzed and executed by the CPU or with hardware based on wired logic.

### Calculation Programs

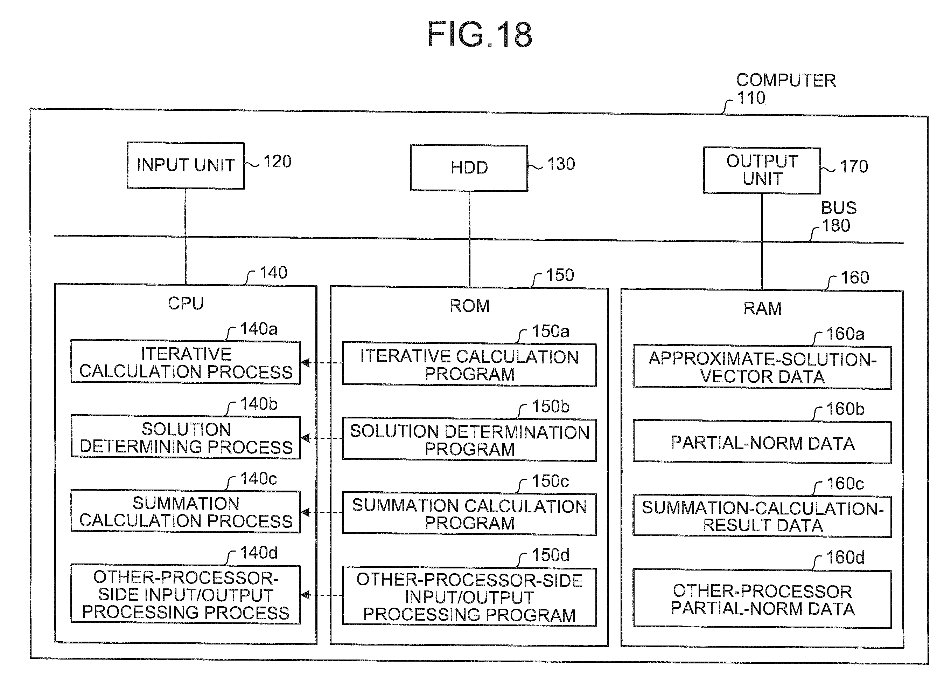

In the above embodiments, various processes are realized with hardware logic. The present invention is not limited to this, and programs may be previously prepared and executed by computers. With reference to FIG. 18, the following describes an example of a computer that executes calculation programs with the same functions as the computer system described in the above embodiments. FIG. 18 is a diagram illustrating a computer for executing calculation programs.

As illustrated in FIG. 18, in a computer 110, which is a display apparatus, an input unit 120, an HDD 130, a CPU 140, a ROM 150, a RAM 160, and an output unit 170 are connected together on a bus 180 and the like.

The ROM 150 previously stores therein calculation programs with the same functions as the processor 10 described in the first embodiment above, i.e., an iterative calculation program 150a, a solution determination program 150b, a summation calculation program 150c, and other-processor-side input/output processing program 150d. The programs 150a to 150d may be arbitrarily integrated or disintegrated similarly to the components in the processor 10 illustrated in FIG. 3.

The CPU 140 reads these programs 150a to 150d from the ROM 150 and executes them. As illustrated in FIG. 18, the programs 150a to 150d function as an iterative calculation process 140a, a solution determination process 140b, a summation calculation process 140c, and an other-processor-side input/output processing process 140d, respectively. The processes 140a to 140d correspond to the solution determining unit 26, the summation calculation unit 35, the other-processor-side input/output processing unit 36, respectively, illustrated in FIG. 3.

The CPU 140 executes the calculation programs according to the approximate-solution-vector data 160a, the partial-norm data 160b, the summation-calculation-result data 160c, and other-processor partial-norm data 160d.

The above-mentioned programs 150a to 150d may not be necessarily stored in the ROM 150 at the start. For example, the programs may be stored in a "portable physical medium" that can be inserted into an inside or outside of the computer 110, such as flexible disk (FD), CD-ROM, DVD disk, magnetic optical disk, and IC card, or may be stored in "fixed physical medium" that are installed inside or outside the computer 110, such as HDD, or may be read from "other computers (or servers)" that are connected with the computer 110 via public lines, the Internet, LAN, WAN, or the like, so that the computer 110 can read the programs therefrom and executes the programs.

### INDUSTRIAL APPLICABILITY

As described, in a computer apparatus, a calculation method, and a calculation program are useful in a case where calculating processes are executed being shared among a plurality of computer apparatuses that is connected with each other via transmission units; the significance of the calculation result calculated by itself is determined using calculation results calculated by other calculation processors; and the calculating processes are repeatedly performed until the calculation result is determined to be significant, and particularly suitable for a case where the transmission overhead in the calculating processes with the iterative solution technique takes a long period of time.

## Claims

1. A computer apparatus for sharing calculating processes with a plurality of computer apparatuses that are connected with each other via a transmission unit, determining a significance of a calculation result calculated by the computer apparatus itself using calculation results calculated by other calculation processors, and performing repeatedly the calculating processes until the calculation result is determined to be significant, the computer apparatus comprising:
an iterative calculation unit that, after its own calculation result is calculated with the calculating processes, does not wait for a determination as to whether the calculation result is significant but does repeatedly perform the calculating processes;
a significance determining unit that, after the calculating processes are started by the iterative calculation unit and when the significance can be determined because of reception of calculation results from other computer apparatuses via the transmission unit, determines whether its own calculation result is significant; and
a suspension unit that, when the calculation result is determined to be significant by the significance determining unit, suspends the calculating processes performed by the iterative calculation unit.

2. The computer apparatus according to claim 1, wherein
the iterative calculation unit repeatedly calculates, in the calculating processes, a solution vector of linear simultaneous equations.

3. The computer apparatus according to claim 1, wherein
the significance determining unit determines the significance, after the calculating processes are started by the iterative calculation unit and when an indication that the significance can be determined is transmitted from the transmission unit.

4. The computer apparatus according to claim 1, wherein
the significance determining unit sends, after the calculating processes are started by the iterative calculation unit, a request as to whether the significance can be determined to the transmission unit, and determines the significance when an indication that the significance can be determined is received as a result of the request.

5. The computer apparatus according to claim 4, wherein
the significance determining unit sends a request as to whether the significance can be determined to the transmission unit at predetermined progress intervals of the calculating processes.

6. The computer apparatus according to claim 4, wherein
the significance determining unit sends a request as to whether the significance can be determined to the transmission unit every time transmission with other computer apparatuses is to be performed in the calculating processes.

7. The computer apparatus according to any one of claims 1 to 6, wherein
the iterative calculation unit calculates the calculation result repeatedly and excessively by one time.

8. A calculation method for performing calculating processes shared among a plurality of computer apparatuses that are connected with each other via a transmission unit, determining a significance of a calculation result calculated by a computer apparatus itself using calculation results calculated by other calculation processors, and performing repeatedly the calculating processes until the calculation result is determined to be significant, the calculation method comprising:
an iterative calculation step of repeatedly performing the calculating processes without waiting for a determination as to whether the calculation result is significant, after its own calculation result is calculated with the calculating processes;
a significance determining step of determining whether its own calculation result is significant after the calculating processes are started at the iterative calculation step and when the significance can be determined because of reception of calculation results from other computer apparatuses via the transmission unit; and
a suspension step of suspending the calculating processes performed at the iterative calculation step, when the calculation result is determined to be significant at the significance determining step.

9. A calculation program for causing a computer to execute a calculation method for performing calculating processes shared among a plurality of computer apparatuses that are connected with each other via a transmission unit, determining a significance of a calculation result calculated by a computer apparatus itself using calculation results calculated by other calculation processors, and performing repeatedly the calculating processes until the calculation result is determined to be significant, the calculation program causing the computer to execute:
an iterative calculation step of repeatedly performing the calculating processes without waiting for a determination as to whether the calculation result is significant, after its own calculation result is calculated with the calculating processes;
a significance determining step of determining whether its own calculation result is significant after the calculating processes are started at the iterative calculation step and when the significance can be determined because of reception of calculation results from other computer apparatuses via the transmission unit; and
a suspension step of suspending the calculating processes performed at the iterative calculation step, when the calculation result is determined to be significant at the significance determining step.
